(19) Europäisches Patentamt
European Patent Office
Office européen des brevets

(11) **EP 2 064 597 B1**

(12) **EUROPÄISCHE PATENTSCHRIFT**

(45) Veröffentlichungstag und Bekanntmachung des Hinweises auf die Patenterteilung:
**10.10.2012 Patentblatt 2012/41**

(21) Anmeldenummer: **07786264.7**

(22) Anmeldetag: **23.07.2007**

(51) Int Cl.:
***G03F 7/20*** (2006.01)

(86) Internationale Anmeldenummer:
**PCT/EP2007/006520**

(87) Internationale Veröffentlichungsnummer:
**WO 2008/022683 (28.02.2008 Gazette 2008/09)**

(54) **BELEUCHTUNGSSYSTEM MIT EINEM DETEKTOR ZUR AUFNAHME EINER LICHTINTENSITÄT**

ILLUMINATION SYSTEM WITH A DETECTOR FOR RECORDING A LIGHT INTENSITY

SYSTEME D'ECLAIRAGE AVEC UN DETECTEUR POUR CAPTER UNE INTENSITE DE LUMIERE

(84) Benannte Vertragsstaaten:
**DE FR NL**

(30) Priorität: **24.08.2006 DE 102006039760**
**24.08.2006 US 823405 P**

(43) Veröffentlichungstag der Anmeldung:
**03.06.2009 Patentblatt 2009/23**

(73) Patentinhaber: **Carl Zeiss SMT GmbH**
**73447 Oberkochen (DE)**

(72) Erfinder: **OSSMANN, Jens**
**73430 Aalen (DE)**

(74) Vertreter: **Carl Zeiss AG - Patentabteilung**
**Carl-Zeiss-Strasse 22**
**73447 Oberkochen (DE)**

(56) Entgegenhaltungen:
**EP-A- 0 884 651        EP-A- 0 987 601**
**US-A1- 2004 084 632   US-B1- 6 259 510**
**US-B1- 7 023 885      US-B2- 6 658 084**

**Beschreibung**

**Gebiet der Erfindung**

Die Erfindung betrifft ein Beleuchtungssystem für eine Mikrolithographie-Projektionsbelichtungsanlage für Wellenlängen ≤ 100 nm, insbesondere ein Beleuchtungssystem im EUV-Wellenlängenbereich, wobei das Beleuchtungssystem eine Lichtquelle zur Ausleuchtung einer Austrittspupillenebene umfasst, sowie wenigstens ein Element zur Veränderung der Ausleuchtung in der Austrittspupillenebene. Des Weiteren betrifft die Erfindung auch noch ein Verfahren zur Einstellung einer im Wesentlichen gleichen Lichtenergie, insbesondere integrierten Lichtenergie entlang eines Scanweges, wenn die Ausleuchtung in der Austrittspupillenebene, die auch als das Setting einer Mikrolithographie-Projektionsbelichtungsanlage bezeichnet wird, verändert wird.

**Stand der Technik**

Um die Strukturbreiten für elektronische Bauteile noch weiter reduzieren zu können, insbesondere in den Submikron-Bereich, ist es erforderlich, die Wellenlänge des für die Mikrolithographie eingesetzten Lichtes zu verringern. Denkbar ist die Verwendung von Licht mit Wellenlängen kleiner 100 nm, beispielsweise die Lithographie mit weichen Röntgenstrahlen, die so genannte EUV-Lithographie.

Die für die EUV-Lithographie verwandten Wellenlängen liegen bevorzugt zwischen 8 und 20 nm, bevorzugt zwischen 11 und 14 nm, insbesondere bei 13,5 nm.

Die EUV-Lithographie ist eine der vielversprechendsten zukünftigen Lithographietechniken. Als Wellenlängen für die EUV-Lithographie werden derzeit Wellenlängen im Bereich 11 - 14 nm, insbesondere 13,5 nm diskutiert bei einer numerischen Apertur von 0,2 -0,3 am Wafer. Die Bildqualität in der EUV-Lithographie wird bestimmt einerseits durch das Projektionsobjektiv, andererseits durch das Beleuchtungssystem. Das Beleuchtungssystem soll eine möglichst gleichförmige Ausleuchtung der Feldebene, in der die strukturtragende Maske, das so genannte Retikel, angeordnet ist, zur Verfügung stellen. Das Projektionsobjektiv bildet die Feldebene in eine Bildebene, die so genannte Waferebene ab, in der ein lichtsensitives Objekt angeordnet ist. Im Allgemeinen sind Projektionsbelichtungsanlagen für die EUV-Lithographie sogenannten Mikrolithographie-Projektionsbelichtungsanlagen mit reflektiven optischen Elementen ausgeführt. Umfasst ein Beleuchtungssystem ausschließlich reflektive optische Elemente, so wird es als katoptrisches Beleuchtungssystem bezeichnet. Umfasst ein Projektionssystem ausschließlich reflektive optische Elemente, so wird es als katoptrisches Projektionssystem bezeichnet. Umfassen sowohl das Beleuchtungssystem wie das Projektionssystem ausschließlich reflektive optische Elemente, so wird die Mikrolithographie-Projektionsbelichtungsanlage als katoptrische Mikrolithographie-Projektionsbelichtungsanlage bezeichnet. Die Form des Feldes in der Bildebene einer EUV-Projektionsbelichtungsanlage ist typischerweise die eines Ringfeldes mit einem hohen Aspektverhältnis, das durch eine Breite und eine Bogenlänge definiert ist. Bevorzugt ist die Breite ≥ 1 mm, insbesondere bevorzugt ≥ 2 mm. Die Bogenlänge ist insbesondere ≥ 22, bevorzugt ≥ 26 mm. Die Projektionsbelichtungsanlagen werden üblicherweise im Scanning Mode betrieben. Betreffend EUV-Projektionsbelichtungsanlagen wird auf die nachfolgenden Schriften verwiesen:

    US 2005/0088760 A
    US 6,438,199 B
    US 6,859,328 B

Um die Ausleuchtung in der Pupillenebene, das sog. Abbildungssetting bzw. den Kohärenzgrad der Beleuchtung einzustellen, wird im Stand der Technik eine Einstellung der Ausleuchtung bei EUV-Systemen mit Hilfe einer in oder in der Nähe der Pupillenebene bzw. einer konjugierten Pupillenebene angeordneten Blende vorgeschlagen. Bei der Einstellung des Settings bzw. der Ausleuchtung mit Hilfe einer Blende tritt beispielsweise bei einer Variation des Settings bspw. von σ=0,8 zu σ=0,5 ein geometrischer Lichtverlust auf, der bei 60 % liegt.

Alternativ zu einer Settingeinstellung mit Blenden schlägt die US 6,658,084 vor, die Settingeinstellung durch eine Variation der Zuordnung der Lichtkanäle in einem doppelt facettierten Beleuchtungssystem vorzunehmen. Bei einem katoptrischen Beleuchtungssystem mit zwei facettierten optischen Elementen sind die ersten Rasterelemente des ersten facettierten optischen Elementes als erste Facettenspiegel und die zweiten Rasterelemente des zweiten facettierten optischen Elementes als zweite Facettenspiegel ausgebildet. Hierzu kann bspw. das erste facettierte optische Element, der sogenannte Feldfacettenspiegel ausgetauscht werden. Allerdings führt auch der Austausch von optischen Elementen zu einer Veränderung der Transmission im Beleuchtungssystem. Bspw. verursacht der Austausch des ersten facettierten optischen Elementes eine Änderung der geometrischen Effizienz, da üblicherweise nicht das gesamte von der Lichtquelle zur Verfügung gestellte Licht genutzt werden kann. Stellt man eine Veränderung der Kanalzuordnung nicht durch einen Tausch des ersten facettierten optischen Elementes, sondern durch ein Verkippen von Spiegeln bspw. auf dem zweiten facettierten Element ein, so ergibt sich ebenfalls eine Veränderung der Transmission des gesamten Systems, da die das EUV-Licht reflektierenden Facettenspiegel des zweiten facettierten optischen Elements mit Vielfachschichten versehen sind, die auf einen Einfallswinkel optimiert sind. Werden diese verkippt, so nimmt die Reflektivität ab und auch hier tritt eine Änderung der Transmission im Beleuchtungssystem ein.

Da jegliche Transmissionsänderung des Beleuchtungssystems zu einer Veränderung der Lichtstärke im Bereich des auszuleuchtenden Feldes in der Objekt- bzw. als Folge auch in der Bildebene der Mikrolithographie-Projektionsbelichtungsanlage führt, überträgt sich eine derartige Schwankung der Lichtintensität, auf das in der Bildebene angeordneten lichtsensitive Substrat.

Um gleichbleibende Fertigungsergebnisse zu erzielen ist es aber notwendig, dass das in der Bildebene angeordnete Substrat stets mit der gleichen integrierten Lichtleistung entlang des Scanweges beaufschlagt wird.

Aus dem Stand der Technik sind daher Beleuchtungssysteme bekannt geworden, mit denen die Lichtintensität in der Feldebene gemessen bzw. eingestellt werden kann. Diesbezüglich wird auf nachfolgende Schriften verwiesen:

    EP 1291721 A
    EP 1355194 A
    US 2002/0190228 A
    WO 2004/031854 A
    US 6,885,432 B
    US 2005/0110972 A
    US 6,259,510 B1

Nachteilig an den aus dem Stand der Technik bekannten Systemen war, dass beispielsweise wie in der US 2005/0110972 A beschrieben zur Einstellung der Ausleuchtung in der Feldebene, Licht der Lichtquelle ausgeblendet wurde. Dies hat den Nachteil von Lichtverlusten.

Im Zusammenhang mit Blenden zur Einstellung des Settings offenbart die US 6,259,510 B1 die geeignete Variation einer Scan-Geschwindigkeit.

**Zusammenfassung der Erfindung**

Lichtverluste führen unter Anderem dazu, dass die Scangeschwindigkeit der Projektionsbelichtungsanlage relativ niedrig wird, da zur Belichtung einer lichtempfindlichen Schicht, beispielsweise eines Fotolackes stets eine bestimmte Lichtmenge benötigt wird. Wird weniger Licht pro Zeiteinheit zur Verfügung gestellt, weil beispielsweise Lichtpulse der Lichtquellen ausgeblendet werden, so sinkt zwangsläufig die Scan-Geschwindigkeit der MikrolithographieProjektionsbelichtungsanlage.

Aufgabe der Erfindung ist es somit ein Beleuchtungssystem und ein Verfahren anzugeben, mit dem auch bei einer Einstellung der Ausleuchtung in der Austrittspupillenebene - insbesondere bei Änderung des Kohärenzgrades oder bei einem Settingwechsel - in der Bildebene, in der der zu belichtende Wafer angeordnet ist, stets eine gleiche Lichtintensität, insbesondere integrierte Lichtintensität zur Verfügung gestellt wird, wobei die Nachteile des Standes der Technik vermieden werden, insbesondere die Lichtverluste minimiert werden.

Erfindungsgemäß wird diese Aufgabe dadurch gelöst, dass im Beleuchtungssystem wenigstens ein Detektor zur Detektion von Licht der Lichtquelle vorgesehen ist. Der Detektor kann vor, am oder hinter einem Element zur Veränderung der Ausleuchtung in der Austrittspupillenebene angeordnet sein. Des Weiteren umfasst das Beleuchtungssystem eine Vorrichtung, die das Lichtintensitätssignal aufnimmt und in Abhängigkeit vom Lichtintensitätssignal ein Steuersignal für die Scangeschwindigkeit eines lichtempfindlichen Objektes einstellt. Eine derartige Vorrichtung wird als Regeleinheit bezeichnet.

Um die Lichtintensität in der Ebene, in der das lichtempfindliche Objekt angeordnet ist, bei unterschiedlichen Ausleuchtungen der Austrittspupillenebene weitgehend konstant halten zu können, wird erfindungsgemäß das Lichtintensitätssignal, das vom Detektor aufgenommen wird, an die oben beschriebene Regeleinheit übermittelt. Ändert sich aufgrund einer geänderten Ausleuchtung der Austrittspupillenebene durch eine Settingeinstellung bzw. eine Einstellung des Kohärenzgrades des Beleuchtungssystems die Transmission des Beleuchtungssystems bzw. der Mikrolithographie-Projektionsbelichtungsanlage, so ändert sich die Lichtintensität in der Ebene, in der das lichtempfindliche Objekt angeordnet ist. Die Lichtintensität in der Ebene, in der das lichtempfindliche Objekt angeordnet ist kann sich aber auch durch Schwankungen der Quellintensität und Degradationseffekte der optischen Flächen ändern. Zumindest die Änderungen der Lichtintensität, die auf die Schwankungen zurückgehen, können mit Hilfe des Detektors bestimmt werden. Um in der Ebene, in der das lichtempfindliche Objekt angeordnet ist, im Wesentlichen die gleiche Lichtintensität zur Verfügung zu stellen, wird erfindungsgemäß mit der Regeleinheit die sog. Scan-Geschwindigkeit, das ist die Geschwindigkeit mit der das zu belichtende Objekt d.h. der lichtempfindliche Wafer in der Bildebene bewegt wird, variiert bzw. eingestellt. Dabei wird die vom Detektor aufgenommene Intensität sowie weitere Information darüber welche Ausleuchtung in der Pupillenebene eingestellt wurde, von der Regeleinheit berücksichtigt.

Die vom Wafer entlang des Scanweges aufgenommene Lichtmenge kann durch eine Regelung bzw. Steuerung wie oben beschrieben bei Veränderung der Transmission des Beleuchtungsystems konstant gehalten werden.

Ein Beleuchtungssystem kann derart ausgestaltet sein, dass das Element zur Veränderung der Ausleuchtung ein tauschbares facettiertes optisches Element ist, bspw. bei einem doppelt facettierten Beleuchtungssystem mit einem ersten facettierten Element umfassend Feldfacetten und einem zweiten facettierten Element umfassend Pupillenfacetten, wie in der US 6,658,084 offenbart ein tauschbares erstes facettiertes Element mit Feldfacetten.

Durch den Tausch des ersten facettierten Elementes mit Feldfacetten wird die Zuordnung von Feld- und Pupillenfacetten in dem doppelt facettierten Beleuchtungssystem geändert und damit das Setting bzw. die Ausleuchtung in der Austrittspupillenebene wie in der US 6,658,084 offenbart. Alternative kann Eine derartige Änderung der Zuordnung und damit Einstellung der Ausleuchtung der Austriaspupillenebene dadurch erreicht werden, dass einzelne Feld- und/oder Pupillenfacetten kippbar ausgelegt sind.

In einer besonders vorteilhaften Ausführungsform der Erfindung ist vorgesehen, dass in der Regeleinheit eine Tabelle mit Regelgrößen für unterschiedliche Settingeinstellungen hinterlegt ist. Die Tabelle enthält bevorzugt Kalibrierwerte, die mit Hilfe von Messungen der Intensitätsverteilung beispielsweise in der Feldebene und/oder der Bildebene bei unterschiedlichen Beleuchtungssettings erhalten werden. So kann beispielsweise bei einer ersten Einstellung eines Settings bzw. ersten Settingeinstellung der Intensitätswert 100 ermittelt werden, bei einer zweiten Einstellung eines Settings bzw. der zweiten Settingeinstellung der Intensitätswert 50. Wird die Beleuchtung von der ersten Settingeinstellung auf die zweite Settingeinstellung geändert, so halbiert man die Scangeschwindigkeit und stellt damit sicher, dass für beide Settingeinstellungen in etwa dieselbe Dosisleistung in der Bildebene auftrifft. Eine Regelung bevorzugt im laufenden Betrieb der Mikrolithographie-Projektionsbelichtungsanlage mit Hilfe von Kalibriertabellen oder alternativ Eichkurven ist dann vorteilhaft, wenn mehr als zwei unterschiedliche Ausleuchtungen bzw. Settings realisiert werden. Werden in einem System nur zwei Setting-Einstellungen realisiert, so kann eine Regelung bzw. Steuerung mit Hilfe einer Differenzmessung bevorzugt im laufenden Betrieb erfolgen.

Laufender Betrieb bedeutet in vorliegender Anmeldung, dass die Regelung während der Prozessierung des lichtempfindlichen Objektes, insbesondere während der Belichtung des lichtempfindlichen Objektes erfolgt.

Die Detektoren zur Bestimmung der aktuellen Lichtintensität während beispielsweise des Belichtungsprozesses können im Lichtweg vor oder nach der Vorrichtung zur Einstellung der Ausleuchtung in der Austrittspupillenebene bevorzugt in oder in der Nähe der Austrittspupillenebene und/oder einer zur Austrittspupillenebene konjugierten Ebene und/oder in oder in der Nähe der Feldebene und/oder einer zur Feldebene konjugierten Ebene des Beleuchtungssystems angeordnet sein. Der Detektor kann sowohl innerhalb des Lichtweges angeordnet sein oder außerhalb. Ist der Detektor außerhalb des Lichtweges von der Lichtquelle zur Bildebene angeordnet ist, so wird bspw. im Lichtweg ein Spiegel angeordnet, mit dem ein Teil des Lichtes aus dem Lichtweg ausgekoppelt und auf einen Detektor gelenkt wird.

Neben dem Beleuchtungssystem stellt die Erfindung auch eine Mikrolithographie-Projektionsbelichtungsanlage mit einem derartigen Beleuchtungssystem zur Verfügung, sowie ein Verfahren zur Einstellung einer im Wesentlichen gleichen Lichtenergie oder integrierten Lichtenergie entlang des Scanweges in der Bildebene. Dies bedeutet, dass mit dem erfindungsgemäßen Verfahren für unterschiedliche Ausleuchtungen immer im wesentlichen dieselbe integrierte Scanenergie entlang eines Scanweges eingestellt werden kann. Die integrierte Scanenergie zu einer Feldhöhe x entlang eines Weges y in der Bildebene ist definiert als:

$$SE(x) = \int I(x,y)\, dy$$

wobei I (x,y) die Intensität des Lichtes, das für die Belichtung genutzt wird, d.h. die Intensität der Nutzstrahlung von z.B. 13,5 nm an einem Punkt x,y in der Bildebene ist. Mit anderen Worten versteht man unter der integrierten Scanenergie SE die gesamte Lichtenergie, mit der ein Punkt auf dem lichtsensitiven Substrat, das in der Feldebene der Projektionsbelichtungsanlage angeordnet ist, im Verlauf eines Scanvorganges beaufschlagt wird.

Beträgt beispielsweise die Scanenergie SE entlang eines Scanweges vor Änderung der Ausleuchtung SE(a1), so wird mit dem erfindungsgemäßen Verfahren erreicht, dass die integrierte Scanenergie SE(a2) nach Änderung der Ausleuchtung im wesentlichen mit der integrierten Scanenergie SE(a1) übereinstimmt, d.h. es gilt SE(a1) ≈ SE(a2). Besonders bevorzugt ist es, wenn dies für die integrierten Scanenergien SE(a1) und SE (a2) an jeder Feldhöhe x des lichtsensitiven Substrates in der Bildebene der Projektionsbelichtungsanlage gilt.

Gemäß dem erfindungsgemäßen Verfahren wird hierzu in einer Ausgestaltung zunächst die Lichtenergie vor Veränderung der Ausleuchtung in der Austrittspupillenebene gemessen, sodann die Lichtenergie, die sich nach einer Veränderung der Ausleuchtung ergibt und ein Differenzsignal aufgenommen. Das Differenzsignal wiederum ist ein Maß dafür, wie stark die Scan-Geschwindigkeit des zu belichtenden Objektes und/oder des lichtempfindlichen Substrates variiert werden muss, um eine im Wesentlichen gleiche integrierte Lichtenergie, insbesondere integrierte Scanenergie in der Bildebene der Mikrolithographie-Projektionsbelichtungsanlage zur Verfügung zu stellen, auch bei geänderter Ausleuchtung.

Alternativ zur Aufnahme eines Differenzsignales kann vorgesehen sein, dass Kalibrierwerte in der Regeleinheit hinterlegt werden. Die Kalibrierwerte werden durch Messung der Intensitätsverteilung bei unterschiedlichen Ausleuchtungen bzw. Beleuchtungssettings erhalten. Beispielsweise können die Kalibrierwerte in einer Kalibriertabelle oder einer Kalibrierkurve hinterlegt sein. Wird ein Beleuchtungssetting geändert, so wird die Scangeschwindigkeit des zu belichtenden lichtempfindlichen Substrates entsprechend den Werten, die als Kalibrierwerte hinterlegt sind geändert und so sichergestellt, dass auch bei unterschiedlichen Settingeinstellungen in etwa dieselbe Dosisleistung in der Bildebene auftrifft.

Der Vorteil des erfindungsgemäßen Systems beispielsweise gegenüber dem aus der US 2005/0110972 A bekannten System ist, dass zur Regelung der Scangeschwindigkeit kein Licht der Lichtquelle ausgeblendet werden muss und so die Scangeschwindigkeit der Projektionsbelichtungsanlage höher ist. Damit ist auch der Durchsatz einer Projektionsbelichtungsanlage mit einem erfindungsgemäßen Beleuchtungssystem höher. Bei einem System gemäß der US 2005/011972 A wird hingegen ein Teil des Lichtes ausgeblendet und steht somit nicht zur Belichtung eines lichtempfindlichen Objektes bzw. eines Wafers in der Bildebene zur Verfügung Beim erfindungsgemäßen System wird dagegen alles Licht der Lichtquelle genutzt. Ein weiterer Vorteil des Systems gemäß der Erfindung ist, dass eine kontinuierliche Intensitätsänderung möglich ist. Bei dem in der US 2005/0110972 beschriebenen System können über den Shutter hingegen nur ganze Impulse ausgeblendet werden.

Im Gegensatz zu einem diskontinuierlichen Verfahren, wie im Stand der Technik beschrieben, kann gemäß der Erfindung die Scangeschwindigkeit kontinuierlich auf jeden beliebigen Wert eingestellt werden und so eine kontinuierliche Regelung erreicht werden.

**Detaillierte Beschreibung der Erfindung**

Die Erfindung wird anhand der Figuren nachfolgend detailliert beispielhaft beschrieben. Es zeigen:

Fig. 1        die Form des auszuleuchtenden Feldes in der Objektebene

Fig. 2a - 2b        unterschiedliche Ausleuchtungen in der Pupillenebene

Fig. 3        den Aufbau eines Beleuchtungssystems mit einer erfindungsgemäßen Vorrichtung

Fig. 4a-b        die Anzahl der Lichtpulse, die bei einer getakteten Lichtquelle auf ein zu belichtendes Objekt auftreffen in Abhängigkeit von der Scangeschwindigkeit

Fig. 5        ein Flussdiagramm einer beispielhaften Regelung

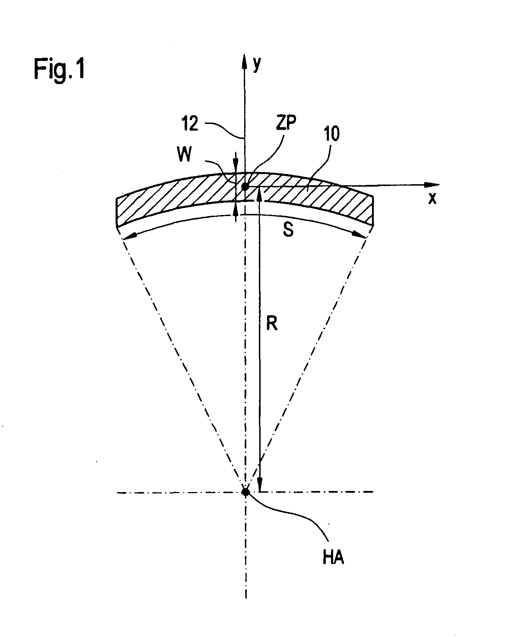

In Figur 1 ist das in der Feldebene ausgeleuchtete Feld dargestellt. Das Feld ist mit der Bezugsziffer 10 gekennzeichnet. Das Feld weist eine bogenförmige Form auf. Eingezeichnet ist der zentrale Feldpunkt ZP des Feldes 10 sowie der Feldradius R. Der Feldradius R ergibt sich aus dem Abstand zur optischen Achse HA des Projektionsobjektives. Des Weiteren eingezeichnet ist die Bogenlänge s und das lokale x-, y-, z-Koordinatensystem im zentralen Feldpunkt ZP des Feldes als Ursprung. Das Feld 10 wird in der durch die x-Richtung und die y-Richtung aufgespannten Feldebene ausgebildet. Die Ausleuchtung in der Bildebene hat im Wesentlichen dieselbe Form wie das in der Objektebene ausgeleuchtete Feld. Das in der Objektebene bzw. Feldebene ausgeleuchtete Feld wird durch ein Projektionssystem bzw. ein Projektionsobjektiv in der Bildebene abgebildet. Handelt es sich bei dem Projektionssystem um ein Reduktionssystem, so wird das Feld in der Objektebene verkleinert in die Bildebene abgebildet. Beispielsweise wird bei einem 4:1 Projektionssystem das Feld in der Objekt oder Feldebene 4-fach verkleinert in die Bildebene abgebildet. Im vorliegenden Ausführungsbeispiel wird eine Maske in der Objektebene und/oder das lichtempfindliche Objekt in der Bildebene entlang der y-Richtung bewegt. Damit ist die y-Richtung die sog. Scanrichtung der Mikrolithographie-Projektionsbelichtungsanlage. Des Weiteren eingezeichnet ist die Scanschlitzbreite w des Ringfeldes, die in der Bildebene bei Mikrolithographie-Projektionsbelichtungsanlagen bevorzugt $\geq$ 1 mm, besonders bevorzugt $\geq$ 2 mm ist. Die bildseitige Scanschlitzgröße, d. h. Feldgröße beträgt beispielsweise 1 x 22 mm bzw. 2 x 22 mm.

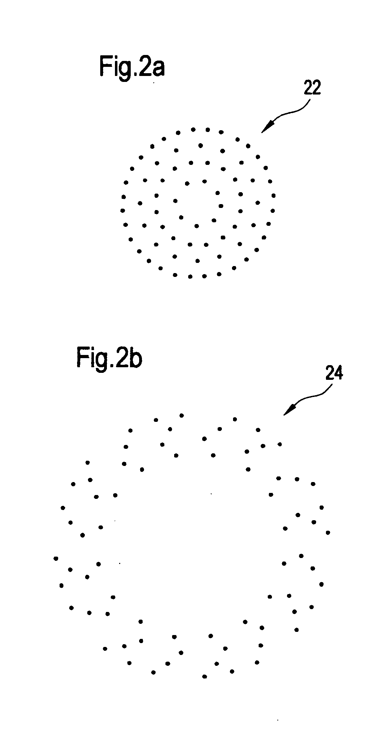

In den Figuren 2a und 2b sind zwei unterschiedliche Ausleuchtungen in der Pupillenebene einer Mikrolithographie-Projektionsbelichtungsanlage gezeigt. Die Figur 2a zeigt eine erste Ausleuchtung 22 mit einem Wert $\sigma$=0,4 in der Pupillenebene bzw. Eintrittspupille im Falle einer kreisförmigen Ausleuchtung des zweiten facettierten Elementes mit Rasterelementen, des sog. Pupillenfacettenspiegels und Figur 2b ein annulares Setting mit

dem Wert $\dfrac{\sigma_{out}}{\sigma_{in}} = \dfrac{0,8}{0,4}$ für eine ringförmige zweite Ausleuchtung 24. Eine derartige Ausleuchtung kann man in einem Beleuchtungssystem einstellen, entweder in dem man eine Blende direkt vor oder in der Nähe des zweiten facettierten Elementes eines doppelt facettierten Beleuchtungssystems anbringt oder aber indem man die Zuordnung zwischen Feld und Pupillenfacetten ändert wie in der US 6,658,084 beschrieben.

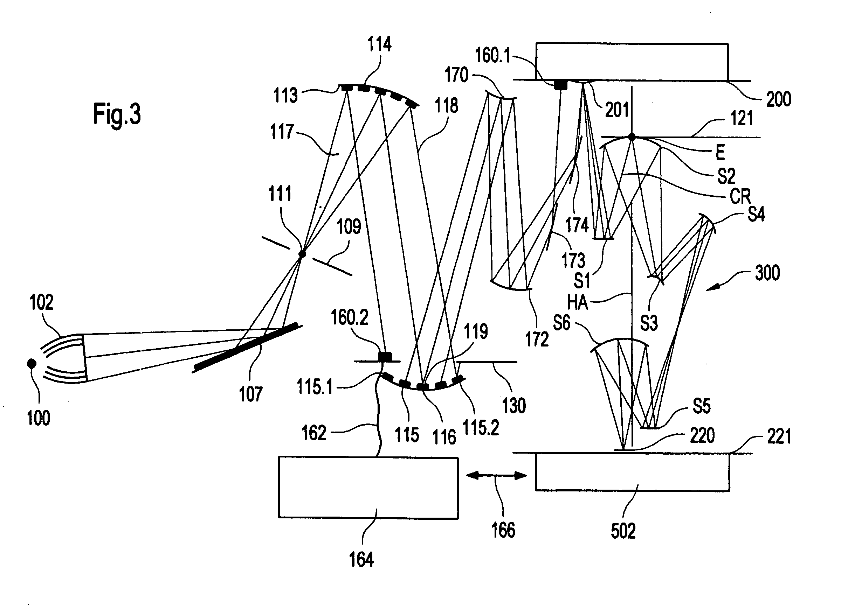

In Figur 3 ist ein Beleuchtungssystem dargestellt, bei dem ein Element zur Veränderung der Ausleuchtung der Austrittspupille, d. h. der Einstellung des Settings in der Nähe des zweiten facettierten Elementes vorgesehen ist. In dem in Figur 3 gezeigten Ausführungsbeispiel ist dies eine Blende 130.

Die Mikrolithographie-Projektionsbelichtungsanlage gemäß Figur 3 umfasst eine Lichtquelle 100, die mit einer bestimmten Wellenlänge Licht mit einer Wellenlänge < 100 nm, beispielsweise Licht im EUV-Wellenlängenbereich im Bereich von ungefähr 8 nm bis 20 nm, insbesondere beispielsweise bei einer Wellenlänge von 13,5 nm emittiert. Das von der Lichtquelle emittierte Licht wird durch den Kollektor 102, der als grazing-incidence-Kollektor gemäß dem in der WO 2002/27400 gezeigten, aufgebaut ist, gesammelt.

Die von der Lichtquelle ausgesandte Strahlung wird mit Hilfe des spektralen Filterelementes 107 zusammen mit der Aperturblende 109 gefiltert, so dass hinter der Aperturblende nur Nutzstrahlung, bspw. von 13,5 nm vorliegt. Der Spektralfilter in Form eines Gitterelementes beugt das auf das Gitterelement auftreffende Licht in unterschiedliche Richtungen bspw. in die -1. Beugungsordnung. Die Aperturblende ist in oder nahe des Zwischenbildes 111 der primären Lichtquelle 100 in der -1. Beugungsordnung angeordnet. Die Projektionsbelichtungsanlage umfasst des Weiteren ein erstes facettiertes optisches Element 113 mit ersten Facetten sog. Feldrasterelementen, die bei katoptrischen Systemen als kleine Facettenspiegel 114 ausgebildet sind und ein zweites optisches Element 115 mit zweiten Facetten sog. Pupillenrasterelementen bzw. Pupillenfacetten, die bei katoptrischen Systemen ebenfalls als Facettenspiegel 116 ausgebildet sind. Die Feldfacetten 114 bzw. die Pupillenfacetten 116 können als Planfacetten ausgebildet sein und wie dargestellt gekippt auf einem Trägerelement angeordnet sein oder als Facetten mit optischer Wirkung beispielsweise positiver oder negativer Brechkraft, wie in der US 6,198,793 dargestellt, ausgebildet sein, deren Offenbarungsgehalt vollumfänglich mit eingeschlossen wird. Das erste optische Element 113, umfassend die Feldfacetten zerlegt das Lichtbüschel 117, das von der primären Lichtquelle 100 her auftrifft in eine Vielzahl von Lichtbündeln 118. Jedes Lichtbündel 118 wird fokussiert und bildet eine sekundäre Lichtquelle 119 am Ort oder nahe des Ortes, an der das zweite optische facettierte Element 115 mit Pupillenrasterelementen angeordnet ist, aus.

Bei der in Figur 3 gezeigten Mikrolithographie-Projektionsbelichtungsanlage wird die Ausleuchtung in der Austrittspupillenebene 121 in der die Austrittspupille des Beleuchtungssystems liegt dadurch eingestellt, dass vor dem zweiten facettierten Element, d. h. dem Pupillenfacettenelement eine Blende 130 angeordnet ist, mit der selektiv bestimmte Pupillenfacetten 115, beispielsweise wie dargestellt, die Pupillenfacette 115.1 ausgeblendet werden können. Auf diese Art und Weise ist es möglich eine Ausleuchtung mit unterschiedlichen Kohärenzwerten, sog. σ-Werten sehr leicht einzustellen. Alternativ könnten auch einzelne Pupillenfacetten zur Ausbildung komplexerer Strukturen wie bspw. quadrupolarer oder dipolarer Ausleuchtung mit Hilfe der Blendenanordnung 130, die vor dem zweiten facettierten optischen Element angeordnet ist eingestellt werden. Dies wird auch als Settingeinstellung bezeichnet. Alternativ zur Einstellung des Kohärenzgrades mittels der dargestellten Blende 130 wäre es auch möglich, eine Einstellung vorzunehmen mit Hilfe einer geänderten Zuordnung der Lichtkanäle von den Feldfacettenelementen zu den Pupillenfacettenelementen.

Eine Einstellung einer Ausleuchtung in der Austrittspupillenebene 121 mittels einer derart geänderten Zuordnung ist in der US 6,658,084 beschrieben.

Erfindungsgemäß ist es vorgesehen, dass die Änderung der Transmission beispielsweise aufgrund von Schwankungen der Lichtquelle oder durch die Einstellung der Ausleuchtungen in der Austrittspupillenebene 121, mit Hilfe wenigstens eines Detektors 160.1 aufgenommen wird. Der Detektor 160.1 ist in dem dargestellten Fall im Lichtweg hinter dem Element mit dem die Änderung der Ausleuchtung in der Pupillenebene vorgenommen wird, hier der Blende 130 angeordnet. Konkret ist der Detektor 160.1 vorliegend in der Objektebene 200 des nachfolgenden Projektionsobjektives 300 angeordnet. Diese Anordnung ist lediglich beispielhaft. Der Detektor 160.1 kann im Lichtweg von der Lichtquelle zur Objektebene auch vor der Vorrichtung zur Änderung der Ausleuchtung, wie beispielsweise Detektor 160.2 oder an der Vorrichtung zur Änderung der Ausleuchtung angeordnet sein. In vorliegendem Beispiel wird das von den Feldfacetten her einfallende Licht an der Pupillenfacette 115.2 reflektiert und auf den im Lichtweg nach dem zweiten facettierten optischen Element 116 liegenden Detektor 160.1 gelenkt. Während in vorliegendem Ausführungsbeispiel der Detektor 160.2 innerhalb des Lichtweges von der Lichtquelle zur Bildebene, vorliegend im Lichtweg von dem ersten facettierten Element 113 zum zweiten facettierten Element 116 liegt, ist der Detektor 160.1 außerhalb des Lichtweges von der Lichtquelle zur Bildebene angeordnet. Das Licht für den Detektor 160.1 wird vorliegend aus dem Lichtweg über ein Auskoppelspiegel 173 ausgekoppelt. Denkbar wäre aber auch eine Anordnung des Detektors 160.1 innerhalb des Lichtweges. Auch ist es möglich, Detektoren an anderen als den gezeigten Stellen einzusetzen, insbesondere beispielsweise in konjugierten Ebene zur Austrittspupillenebene 121 oder Feldebene, die mit der Objektebene 200 zusammenfällt anzuordnen. Des Weiteren kann die Messung mit Hilfe hier eines oder auch mit Hilfe von mehreren Detektoren erfolgen. Je nachdem wo der Detektor platziert ist, werden vom Detektor unterschiedliche Lichtsignale aufgenommen. Ist beispielsweise der Detektor 160.1 im Lichtweg nach der Blende 130 d.h. nach der Vorrichtung zur Settingeinstellung angeordnet, so ergeben sich unterschiedliche Lichtsignale für unterschiedliche Settingeinstellungen. Das vom Detektor 160.1 aufgenommene Lichtsignal kann dann direkt als Steuersignal oder als Regelsignal 162 für eine Steuer-/Regeleinheit 164 zur Einstellung der Scangeschwindigkeit in Abhängigkeit von der Settingeinstellung verwandt werden. Möchte man die Scangeschwindigkeit in Abhängigkeit von der Settingeinstellung anpassen, so müssen zusätzliche Informationen vorliegen. Die Regeleinheit 169 kann mit diesen zusätzlichen Informationen dann auch für einen Detektor 160.2, der im Lichtweg vor der Vorrichtung zur Einstellung des Settings angeordnet ist, für verschiedene Settingeinstellungen die Scangeschwindigkeit entsprechend regeln. Bei den dargestellten Ausführungsformen sind zwei Detektoren 160.1, 160.2 vorgesehen, wobei ein erster Detektor 160.1 zur Detektion der Settingeinstellung im Lichtweg nach der Vorrichtung zur Settingeinstellung angeordnet ist und ein weiterer zweiter Detektor 160.2 zur Detektion von Intensitätsschwankungen beispielsweise der Lichtquelle im Lichtweg vor der Vorrichtung zur Settingeinstellung angeordnet ist. Mit den Signalen dieser beiden Detektoren 160.1, 160.2 lässt sich die Scangeschwindigkeit in Abhängigkeit von Intensitätsschwankungen und Stettingeinstellungen regeln.

Wie zuvor erläutert führt eine Veränderung der Lichttransmission, bspw. bei einer Variation des Settings von σ=0,8 bis σ=0,5, zu einem geometrischen Lichtverlust von 60 %. Diese Änderung kann mit Hilfe der Erfindung kompensiert werden und so sichergestellt werden, dass auf das zu belichtende Objekt in der Bildebene stets die gleiche Lichtmenge auftrifft. Dies kann beispielsweise dadurch erreicht werden, dass in Abhängigkeit vom aufgenommenen Lichtsignal des Detektors 160.2 und/ oder Detektor 160.1 eventuell zusätzlich aufgenommene Informationen die Scan-Geschwindigkeit des Wafers, d. h. des zu belichtenden Substrates in der Bildebene so eingestellt wird, dass auf dem zu belichtenden Substrat in der Bildebene des Projektionsobjektives stets im Wesentlichen die gleiche Lichtmenge auftrifft. Dies stellt sicher, dass eine gleichförmige Belichtung auch bei Veränderung der Transmission aufgrund einer Settingänderung und/oder von Lichtintensitätsschwankungen während des Belichtungsprozesses beibehalten wird.

Im vorliegenden Ausführungsbeispiel sind darüber hinaus im Lichtweg hinter dem zweiten facettierten optischen Element, dem Pupillenfacettenspiegel 116 zwei normal-incidence-Spiegel 170, 172 und ein grazing-incidence-Spiegel 174 zur Abbildung der Pupillenfacetten in eine Eintrittspupille E des Projektionsobjektives und zur Formung des Feldes in der Objektebene 200 dargestellt.

Besitzen die Feldrasterelemente die Form des auszuleuchtenden Feldes, so ist es nicht erforderlich, einen Spiegel für die Feldformung vorzusehen.

Die Eintrittspupille E des Projektionsobjektives, die mit der Austrittspupille in der Austrittspupillenebene 121 des Beleuchtungssystem übereinstimmt, ergibt sich durch den Schnittpunkt der optischen Achse HA des Projektionsobjektives mit dem am Retikel reflektierten Hauptstrahl CR zum zentralen Feldpunkt Z des in Figur 1 gezeigten Feldes.

In der Objektebene 200 der Mikrolithographie-Projektionsbelichtungsanlage ist ein Retikel auf einem Transportsystem angeordnet. Das in der Objektebene 200 angeordnete Retikel wird mit Hilfe des Projektionsobjektives 300 auf ein lichtsensitives Substrat 220 bspw. einen Wafer abgebildet. Der Wafer bzw. das Substrat ist im Wesentlichen in der Bildebene 221 des Projektionsobjektives angeordnet. Die gleichmäßige Belichtung des lichtempfindlichen Substrates wird durch die Regeleinheit 164, die die Scan-Geschwindigkeit des Trägersystems 502 auf der Wafer angeordnet ist, einstellt, in Abhängigkeit von dem vom Detektor 160.1, 160.2 aufgenommenen Lichtsignal, sichergestellt.

Das dargestellte Projektionsobjektiv umfasst sechs Spiegel, einen ersten Spiegel S1, einen zweiten Spiegel S2, einen dritten Spiegel S3, einen vierten Spiegel S4, einen fünften Spiegel S5 und einen sechsten Spiegel S6, die um eine gemeinsame optische Achse HA zentriert angeordnet sind. Das Projektionsobjektiv 300 hat eine positive Schnittweite. Dies bedeutet, dass der Hauptstrahl CR zum zentralen Feldpunkt, der vom Objekt 201 in der Objektebene reflektiert wird in eine Richtung hin zum Objekt 201 in das Projektionsobjektiv läuft. Der Schnittpunkt der optischen Achse HA des Objektivs mit dem am Retikel reflektierten Hauptstrahl CR zum zentralen Feldpunkt ergibt die Lage der Eintrittspupille E, die mit der Austrittspupille des Beleuchtungssystems die in der Austrittspupillenebene 121 des Beleuchtungssystems liegt, übereinstimmt. Durch die Blende 130 bzw. die veränderbare Zuordnung von Feldfacetten zu Pupillenfacetten, wird die Ausleuchtung in der Austrittspupillenebene bzw. in der Eintrittspupille E des Projektionsobjektives geändert, d. h. das Setting dort eingestellt. Bevorzugt ist im Bereich der Eintrittspupille E des Projektionsobjektives eine Aperturblende B, die auch variabel ausgestaltet sein kann, angeordnet.

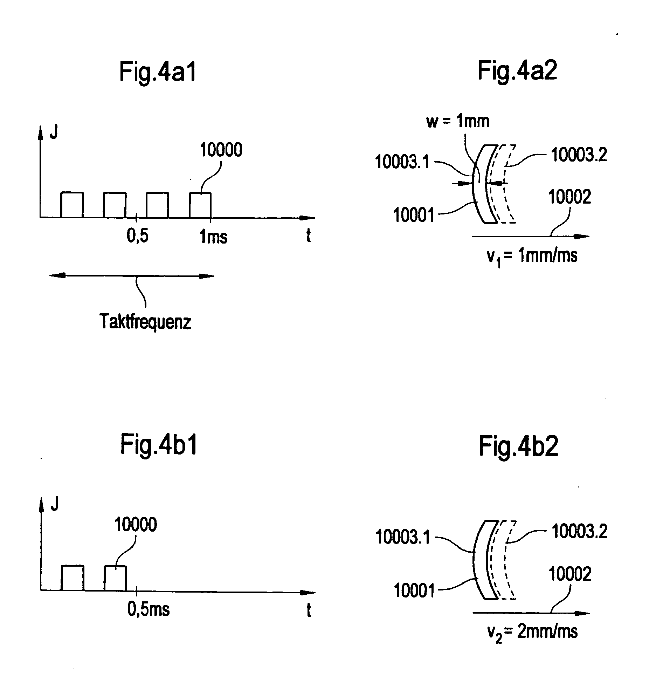

Ist der Detektor 160.2 im Lichtweg nach einer Blende 130 zur Settingeinstellung angeordnet, so wird das von den oder den Detektoren 160.2 aufgenommene Lichtsignal an die Regeleinheit 164 übermittelt. In der Regeleinheit 164 wird das aufgenommene Lichtsignal beispielsweise mit Referenzwerten bzw. Kalibierwerten einer Kalibriertabelle oder einer Eichkurve verglichen und dementsprechend die Scangeschwindigkeit eingestellt. Die Kalibrierwerten können beispielsweise mit Hilfe eines Detektors aufgenommen werden, der zur Aufnahme der Kalibrierwerte in der Bildebene 221, d. h. in der Waferebene angeordnet sein kann. Die sich für verschiedene Settingeinstellungen ergebenden Werte werden in der Tabelle hinterlegt. Die vom Detektor 160.2 im Betrieb tatsächlich gemessenen Werte werden mit den Kalibrierwerten verglichen und dementsprechend die Scangeschwindigkeit geregelt. Beträgt der Wert für eine erste Settingeinstellung 100 und für eine zweite Settingeinstellung 50, so wird die gleiche Lichtmenge in der Bildebene, d. h. auf dem Wafer zur Verfügung gestellt, wenn die Scangeschwindigkeit $v_2$ bei der zweiten Settingeinstellung im Wesentlichen halb so groß ist wie die Scangeschwindigkeit $v_1$ bei der ersten Settingeinstellung. . Werden bei einem derartigen Aufbau zusätzliche Informationen zur Verfügung gestellt, so wird die Scangeschwindigkeit auch an die Settingeinstellung angepasst. An nachfolgenden Figuren 4a bis 4b ist verdeutlicht , welche Auswirkungen eine Änderung der Scangeschwindigkeit auf die Lichtintensität, die pro Zeiteinheit in der Bildebene auftritt, hat.

Bei einer getakteten Lichtquelle wie Sie beispielsweise in der US 2005/0110972 A beschrieben ist, wird pro Zeiteinheit im Wesentlichen die gleiche Anzahl Lichtimpulse abgegeben, wobei pro Lichtimpuls die gleiche Lichtintensität vorliegt. Bei dem Ausführungsbeispiel gemäß Figur 4a.1 sind dies beispielsweise 4 $Impulse/_{ms}$. Wird in der Bildebene der in Figur 4a.2 gezeigte Scanschlitz 10001 mit einer Scanschlitzbreite von 1 mm mit einer Geschwindigkeit $v_1 = 1 mm/_{ms}$ in y-Richtung, d. h. in Scanrichtung 10002 aus der Stellung 10003.1 in die Stellung 10003.2 bewegt, so treffen 4 Lichtimpulse 10000 auf das zu belichtende Objekt in der Bildebene. Der aufgrund der Settingeinstellung ermittelte Kalibrierwert für das Ausführungsbeispiel gemäß Fig. 4a.1 beträgt bspw. 50. Wird nun die Settingeinstellung geändert und beträgt der Kalibrierwert 100 für den in Fig. 4b.1 und Fig. 4b.2 gezeigten Fall, so muss, damit die gleiche Lichtmenge wie in Fig. 4a.1 und 4a.2 auftrifft, die Anzahl der auf die Bildebene auftreffenden Lichtpulse halbiert werden. Dies wird dadurch erreicht, dass die Scangeschwindigkeit auf $v_2 = 2\,mm/_{ms}$ verdoppelt wird. Anstelle von 4 Pulsen treffen lediglich 2 Lichtpulse bei einer Taktfrequenz von 4 impulse/$_{ms}$ auf das zu belichtende Substrat auf.

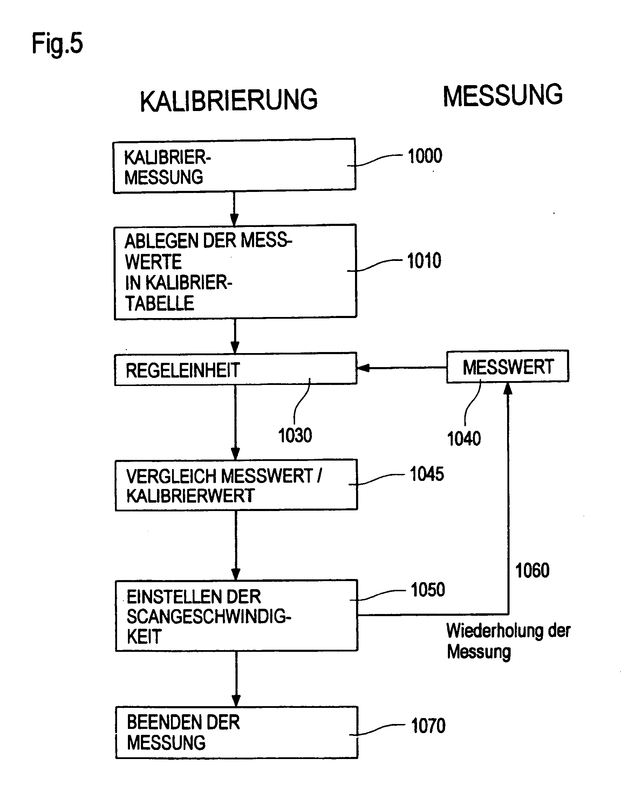

In Fig. 5 ist ein Ablaufdiagramm für eine beispielhafte Regelung dargestellt.

Das in Fig. 5 gezeigte Flussdiagramm ist eine Möglichkeit der Verwertung der Messsignale, die vom Detektor aufgenommen werden zur Steuerung der Scanning-Geschwindigkeit eines lichtempfindlichen Objektes in einer Bildebene. Wie zuvor ausgeführt wird zunächst für verschiedene Settingeinstellungen bzw. Einstellungen der Ausleuchtungen in der Ebene eine Kalibriermessung 1000 durchgeführt. Die Werte der Kalibriermessung werden bspw. in Kalibriertabellen in der Regeleinheit abgelegt. Dies ist mit Schritt 1010 beschrieben. Nachdem die Kalibrierung der Regeleinheit abgeschlossen ist, bspw. in einer Leermessung, d.h. in einem Zustand, in dem das Beleuchtungssystem einer Mikrolithographie-Projektionsbelichtungsanlage nicht für die Belichtung eines lichtempfindlichen Objektes, bspw. eines Wafer eingesetzt wird, sondern lediglich vermessen wird, in dem beispielsweise ein Sensor in die Bildebene des Projektionsobjektives der Projektionsbelichtungsanlage gebracht wird. Dieser Zustand wird auch als Nicht-Betriebszustand bezeichnet.

Die während der Leermessung aufgenommenen Kalibrierwerte werden in der Regeleinheit abgelegt. Wird nunmehr das Beleuchtungssystem in einer Mikrolithographie-Projektionsbelichtungsanlage zur Belichtung eines lichtempfindlichen Wafers eingesetzt, so wird eine bestimmte Setting-Einstellung, d. h. eine Einstellung der Ausleuchtung der Pupillenebene vorgenommen. Aufgrund der von einem Detektor detektierten Lichtintensität und eventueller Zusatzgrößen wie Blendeneinstellungen der Settingblende, die an die Regeleinheit übermittelt wird, wird anhand der Kalibriertabelle ermittelt, mit welcher Geschwindigkeit das zu belichtende Objekt in der Bildebene bewegt werden muss.

Die Regeleinheit ist mit Bezugsziffer 1030 bezeichnet. Der Detektor erfasst das Messsignals in einem Schritt 1040 und übermittelt das Messignal an die Regeleinheit 1030. In der Regeleinheit wird anhand der Kalibriertabelle ein Vergleich in Schritt 1045 vorgenommen und aufgrund dieses Vergleiches die Regelgröße Scan-Geschwindigkeit von der Regeleinheit an bspw. einen Schrittmotor, der die Vorschubgeschwindigkeit des Verschiebetisches bestimmt, auf dem das zu belichtende Objekt angeordnet ist in einem Schritt 1050 übermittelt. Anschließend an Schritt 1050 wird die Messung in Intervallen wiederholt (Schritt 1060) oder beendet (Schritt 1070).

Alternativ zu dem oben beschriebenen sehr aufwendigen Verfahren, das insbesondere dann Anwendung findet, wenn mehr als zwei Settingeinstellungen möglich sind, bzw. wenn mittels einer Blende bspw. kontinuierlich Ausleuchtungen in der Pupillenebene eingestellt werden können, ist es möglich, bei einem System mit lediglich zwei Settingeinstellungen mit Hilfe einer Differenzmessung die Scangeschwindigkeit zu steuern. So kann zunächst eine optimale Scangeschwindigkeit bei einer ersten Ausleuchtung der Austrittspupille ermittelt werden. Hierzu wird eine erste Lichtintensität ermittelt. Wird nunmehr die Ausleuchtung geändert, so ändert sich das Messsignal des Detektors für die Lichtintensität falls der Detektor im Lichtweg nach der Einstellvorrichtung angeordnet ist. Aus einem Differenzsignal vor Änderung der Ausleuchtung und nach Änderung der Ausleuchtung kann dann ermittelt werden, um welchen Wert die Scangeschwindigkeit verändert werden muss, um bei Änderung der Ausleuchtung dasselbe Belichtungsverhalten wie bei der ersten Ausleuchtung sicherzustellen. Wird beispielsweise die Ausleuchtung durch Änderung des Settings um 50 % reduziert, so muss auch die Scangeschwindigkeit gegenüber der Scangeschwindigkeit der ersten Ausleuchtung um 50% reduziert werden, damit dieselbe Lichtmenge auf das zu belichtende Objekt auftrifft, wie im Falle der ersten Ausleuchtung. Ist der Detektor im Lichtweg vor der Anordnung angeordnet mit der die Ausleuchtung , d.h. das Setting eingestellt wird, so ist zur Einstellung der Scangeschwindigkeit in der Ebene des zu belichtenden Objektes zusätzliche Information zusätzlich zum aufgenommenen Lichtsignal erforderlich.

Mit der Erfindung wird somit erstmals eine Vorrichtung sowie ein Verfahren angegeben, mit dem das Licht der Lichtquelle vollständig genutzt werden kann und trotzdem bei Änderung der Ausleuchtung in der Pupillenebene aufgrund von Settingeinstellungen oder Intensitätsschwankungen im Wesentlichen stets die selbe Lichtmenge auf das zu belichtende Objekt auftrifft.

**Patentansprüche**

1. Beleuchtungssystem für eine Mikrolithograhie- Projektionsbelichtungsanlage, wobei das Beleuchtungssystem umfasst:

   - eine Lichtquelle, die Licht im Wellenlängenbereich < 100 nm, insbesondere im EUV-Wellenlängenbereich emittiert, zur Ausleuchtung einer Austrittspupillenebene (121), sowie
   - ein facettiertes optisches Element (113) mit einer Vielzahl von in der Lage veränderbaren Facettenspiegeln, mit dem wenigstens eine erste Ausleuchtung (22) in der Austrittspupillenebene (121) in eine zweite Ausleuchtung (24) geändert werden kann,

**dadurch gekennzeichnet, dass**
das Beleuchtungssystem wenigstens einen Detektor (106.1, 106.2) zur Detektion des Lichtes und eine Vorrichtung (164) umfasst, dazu ausgebildet ist wenigstens ein Lichtintensitätssignal des Detektors (106.1, 106.2) aufennehmen und wenigstens in Abhängigkeit von dem aufgenommenen Lichtintensitätssignal und unter Berücksichtigung von Informationen darüber, welche Ausleuchtung in der Austrittspunillenebene eingestellt wurde, ein Steuersignal (166) zur Verfügung zu stellen, mit dem eine Scan- Geschwindigkeit eines lichtempfindlichen Objektes in einer Bildebene (221) der Mikrolithographie-Projektionsbelichtungsanlage eingestellt werden kann.

2. Beleuchtungssystem nach Anspruch 1,
**dadurch gekennzeichnet, dass**
der Detektor (106.1, 106.2) in einem Lichtweg des Lichtes von der Lichtquelle (100) zur Austrittspupillenebene (121) zwischen der Lichtquelle (100) und der Austrittspupillenebene (121) angeordnet ist.

3. Beleuchtungssystem nach einem der Ansprüche 1 bis 2,
**dadurch gekennzeichnet, dass**
die Vorrichtung ein erstes Einstellsignal aufnimmt, welches eine erste Einstellung des Elements repräsentiert, wobei mit der ersten Einstellung eine erste Ausleuchtung (22) zur Verfügung gestellt wird.

4. Beleuchtungssystem nach Anspruch 3,
**dadurch gekennzeichnet, dass**
die Vorrichtung ein zweites Einstellsignal aufnimmt, welches eine zweite Einstellung des facettierten optischen Elementes (113) repräsentiert, wobei mit der zweiten Einstellung eine zweite Ausleuchtung (26) zur Verfügung gestellt wird.

5. Beleuchtungssystem gemäß einem der Ansprüche 1 bis 4,
**dadurch gekennzeichnet, dass**
die Vorrichtung eine Regeleinheit (1030, 164) mit einer Speichereinheit aufweist, in der wenigstens ein erster Kalibrierwert für die erste Ausleuchtung und ein zweiter Kalibrierwert für die zweite Ausleuchtung abgelegt ist.

6. Beleuchtungssystem gemäß Anspruch 5,
**dadurch gekennzeichnet, dass**
in der Speichereinheit eine Vielzahl von Kalibrierwerten ergebend eine Kalibriertabelle abgelegt sind.

7. Beleuchtungssystem gemäß einem der Ansprüche 1 bis 6,
**dadurch gekennzeichnet, dass**
das lichtempfindliche Objekt auf einem Scantisch (502) angeordnet ist und die Scan-Geschwindigkeit die Vorschub- Geschwindigkeit des Scantisches bestimmt.

8. Beleuchtungssystem gemäß Anspruch 7,
**dadurch gekennzeichnet, dass**
das lichtempfindliche Objekt (220) ein Wafer ist.

9. Beleuchtungssystem nach einem der Ansprüche 1 bis 8,
**dadurch gekennzeichnet, dass**
ein Detektor (160.1) im Lichtweg von der Lichtquelle (100) zur Austrittspupillenebene (121) nach dem facettierten optischen Element (113) zur Änderung der Einstellung der Ausleuchtung angeordnet ist.

10. Beleuchtungssystem nach einem der Ansprüche 1 bis 9,
**dadurch gekennzeichnet, dass**
ein Detektor (160.2) im Lichtweg von der Lichtquelle (100) zur Austrittspupillenebene (121) vor dem facettierten optischen Element (113) zur Änderung der Einstellung der Ausleuchtung angeordnet ist.

11. Beleuchtungssystem nach einem der Ansprüche 1 bis 10,
**dadurch gekennzeichnet, dass**
der Detektor (160.1, 160.2) am oder in der Nähe des facettierten optischen Elements (113) zur Veränderung zur Einstellung der Ausleuchtung der Austrittspupillenebene angeordnet ist.

12. Beleuchtungssystem nach einem der Ansprüche 1 bis 11,
**dadurch gekennzeichnet, dass**
der Detektor (160.1, 160.2) am oder in der Nähe einer Objektebene (200) oder der Bildebene (221) der Mikrolithographie- Projektionsbelichtungsanlage angeordnet ist.

13. Beleuchtungssystem gemäß einem der Ansprüche 1 bis 12,
**dadurch gekennzeichnet, dass**
das Beleuchtungssystem ein katoptrisches Beleuchtungssystem ist.

14. Beleuchtungssystem nach einem der Ansprüche 1 bis 13,
**dadurch gekennzeichnet, dass**
das Beleuchtungssystem ein weiteres facettiertes optisches Element (116) umfasst.

15. Beleuchtungssystem nach Anspruch 14,
**dadurch gekennzeichnet, dass**
das weitere facettierte optische Element (116) eine Vielzahl von Facettenspiegeln (115, 115.1, 115.2) umfasst.

16. Mikrolithographie-Projekionsbelichtungsanlage umfassend ein Beleuchtungssystem gemäß einem der Ansprüche 1 bis 15 mit einer Objektebene(200) sowie einem Projektionsobjektiv (300) zur Abbildung eines in der Objektebene (300) angeordneten Objektes in eine Bildebene (221)

17. Mikrolithographie-Projektionsbelichtungsanlage gemäß Anspruch 16,
**dadurch gekennzeichnet, dass**
das Projektionsobjektiv (300) eine Aperturblende (B) aufweist.

18. Verfahren zur Einstellung einer im Wesentlichen gleichen Lichtenergie, insbesondere integrierten Lichtenergie entlang eines Scanweges in einer Bildebene einer Mikrolithographie-Projektionsbelichtungsanlage für Wellenlängen < 100 nm, insbesondere EUV-Wellenlängen unabhängig von der Ausleuchtung einer Austrittspupillenebene (121), wobei die Mikrolithographie-Projektionsbelichtungsanlage ein facettiertes optisches Element (113) mit einer Vielzahl von in der Lage veränderbaren Facettenspiegeln zur Veränderung der Ausleuchtung in der Austrittspupillenebene und einen Detektor umfasst, mit folgenden Schritten:

    - die Lichtenergie wird vor Veränderung der Ausleuchtung in der Austrittspupillenebene gemessen

    - die Lichtenergie wird nach Veränderung der Ausleuchtung in der Austrittspupillenebene gemessen

    - es wird ein Differenzsignal der vor und nach Veränderung der Ausleuchtung gemessenen Lichtenergie gebildet und aufgrund des Differenzsignals eine Scanning-Geschwindigkeit eines lichtempfindlichen Objektes in der Bildebene eingestellt.

19. Verfahren nach Anspruch 18,
**dadurch gekennzeichnet, dass**
das Differenzsignal kontinuierlich aufgenommen und einer Regeleinheit zugeführt wird und die Scan-Geschwindigkeit des lichtempfindlichen Objektes in der Bildebene kontinuierlich eingestellt wird.

20. Verfahren zur Einstellung einer im Wesentlichen gleichen Lichtenergie, insbesondere integrierten Lichtenergie entlang eines Scanweges in einer Bildebene einer Mikrolithographie-Projektionsbelichtungsanlage für Wellenlängen < 100nm insbesondere EUV-Wellenlängen unabhängig von der Ausleuchtung einer Austrittspupillenebenen, wobei die Mikrolithographie-Projektionsbelichtungsanlage ein facettiertes optisches Element (113) mit einer Vielzahl von in der Lage veränderbaren Facettenspiegeln zur Veränderung der Ausleuchtung in der Austrittspupillenebene aufweist und einen Detektor, mit folgenden Schritten

    - die Lichtenergie wird für unterschiedliche Ausleuchtungen in der Austrittspupillenebene von einem Detektor gemessen,
    - die gemessenen Werte werden als Kalibrierwerte in einer Regeleinheit abgelegt.
    - nach Ablegen der Kalibrierwerte wird die Lichtenergie mittels des Detektors ermittelt und mit den abgelegten Kalibrierwerten verglichen,
    - aufgrund des Vergleiches mit den Kalibrierwerten wird eine Scan-Geschwindigkeit eines lichtempfindlichen Objektes in einer Bildebene eingestellt.

21. Verfahren nach Anspruch 20,
**dadurch gekennzeichnet, dass**
die Kalibrierwerte in Form einer Kalibriertabelle und/oder einer Kalibrierkurve abgelegt werden.

22. Verfahren nach einem der Ansprüche 18 bis 21,
**dadurch gekennzeichnet, dass**
der Detektor am oder in der Nähe des facettiertes optisches Element (113) zur Veränderung zur Einstellung der Ausleuchtung der Pupillenebene angeordnet ist.

23. Verfahren nach einem der Ansprüche 18 bis 22,
**dadurch gekennzeichnet, dass**
die Mikrolithographie-Projektionsbelichtungsanlage eine Objektebene und eine Bildebene aufweist und der Detektor am oder in der Nähe der Objektebene und/oder der Bildebene angeordnet ist.

## Claims

1. Lighting system for a microlithography projection exposure installation, wherein the lighting system comprises:

    - a light source which emits light in the wavelength range < 100 nm, in particular in the EUV wavelength range for illumination of an outlet pupil plane (121), as well as
    - a faceted optical element (113) having a multiplicity of variable-position facet mirrors, by means of which element at least a first illumination (22) on the outlet pupil plane (121) can be changed to a second illumination (24),

**characterized in that**
the lighting system comprises at least one detector (106.1, 106.2) for detection of the light and an apparatus (164) which is designed to receive at least one light intensity signal from the detector (106.1, 106.2), and to make a control signal (166) available at least as a function of the received light intensity signal and taking into consideration information as to which illumination has been adjusted on the outlet pupil plane, by means of which a scanning rate of a light-sensitive object on an image plane (221) of the microlithography projection exposure installation can be adjusted.

2. Lighting system according to Claim 1, **characterized in that** the detector (106.1, 106.2) is arranged in a light path of the light from the light source (100) to the outlet pupil plane (121), between the light source (100) and the outlet pupil plane (121).

3. Lighting system according to one of Claims 1 or 2, **characterized in that** the apparatus receives a first adjustment signal, which represents a first adjustment of the element, wherein a first illumination (22) is made available with the first adjustment.

4. Lighting system according to Claim 3, **characterized in that** the apparatus receives a second adjustment signal, which represents a second adjustment of the faceted optical element (113), wherein a second illumination (26) is made available with the second adjustment.

5. Lighting system according to one of Claims 1 to 4, **characterized in that** the apparatus has a control unit (1030, 164) with a memory unit, in which at least one first calibration value for the first illumination and one second calibration value for the second illumination are stored.

6. Lighting system according to Claim 5, **characterized in that** a multiplicity of calibration values resulting from a calibration table are stored in the memory unit.

7. Lighting system according to one of Claims 1 to 6, **characterized in that** the light-sensitive object is arranged on a scanning table (502), and the scanning rate governs the feed rate of the scanning table.

8. Lighting system according to Claim 7, **characterized in that** the light-sensitive object (220) is a wafer.

9. Lighting system according to one of Claims 1 to 8, **characterized in that** a detector (160.1) is arranged in the light path from the light source (100) to the outlet pupil plane (121) after the faceted optical element (113) for varying the adjustment of the illumination.

10. Lighting system according to one of Claims 1 to 9, **characterized in that** a detector (160.2) is arranged in the light path from the light source (100) to the outlet pupil plane (121), in front of the faceted optical element (113) for varying the adjustment of the illumination.

11. Lighting system according to one of Claims 1 to 10, **characterized in that** the detector (160.1, 160.2) is arranged on or in the vicinity of the faceted optical element (113) for varying the adjustment of the illumination of the outlet pupil plane.

12. Lighting system according to one of Claims 1 to 11, **characterized in that** the detector (160.1, 160.2) is arranged on or in the vicinity of an object plane (200) or the image plane (221) of the microlithography projection exposure installation.

13. Lighting system according to one of Claims 1 to 12, **characterized in that** the lighting system is a catoptric lighting system.

14. Lighting system according to one of Claims 1 to 13, **characterized in that** the lighting system comprises a further faceted optical element (116).

15. Lighting system according to Claim 14, **characterized in that** the further faceted optical element (116) comprises a multiplicity of facet mirrors (115, 115.1, 115.2).

16. Microlithography projection exposure installation comprising a lighting system according to one of Claims 1 to 15 having an object plane (200) as well as a projection objective (300) for imaging an object which is arranged on the object plane (300) on an image plane (221).

17. Microlithography projection exposure installation according to Claim 16, **characterized in that** the projection objective (300) has an aperture stop (B).

18. Method for adjustment of substantially the same amount of light energy, in particular integrated light energy along a scanning path on an image plane of a microlithography projection exposure installation for wavelengths < 100 nm, in particular EUV wavelengths, independently of the illumination of an outlet pupil plane (121), wherein the microlithography projection exposure installation comprises a faceted optical element (113) having a multiplicity of variable-position facet mirrors for varying the illumination on the outlet pupil plane and a detector, having the following steps:

- the light energy is measured before the change in the illumination on the outlet pupil plane,
- the light energy is measured after the change in the illumination on the outlet pupil plane,
- a difference signal between the light energy measured before and after the change in the illumination is formed, and a scanning rate of a light-sensitive object on the image plane is adjusted on the basis of the difference signal.

19. Method according to Claim 18,
**characterized in that**
the difference signal is recorded continuously and is supplied to a control unit, and the scanning rate of the light-sensitive object on the image plane is adjusted continuously.

20. Method for adjustment of substantially the same amount of light energy, in particular integrated light energy along a scanning path on an image plane of a microlithography projection exposure installation for wavelengths < 100 nm, in particular EUV wavelengths, independently of the illumination of an outlet pupil plane, wherein the microlithography projection exposure installation comprises a faceted optical element (113) having a multiplicity of variable-position facet mirrors for varying the illumination on the outlet pupil plane and a detector, having the following steps:

- the light energy is measured by a detector for different illuminations on the outlet pupil plane,
- the measured values are stored as calibration values in a control unit,
- after the calibration values have been stored, the light energy is determined by means of the detector and is compared with the stored calibration values,
- a scanning rate of a light-sensitive object on an image plane is adjusted on the basis of the comparison with the calibration values.

21. Method according to Claim 20,
**characterized in that**
the calibration values are stored in the form of a calibration table and/or a calibration curve.

22. Method according to one of Claims 18 to 21,
**characterized in that**
the detector is arranged on or in the vicinity of the faceted optical element (113) for varying the adjustment of the illumination of the pupil plane.

23. Method according to one of Claims 18 to 22,
**characterized in that**
the microlithography projection exposure installation has an object plane and an image plane, and the detector is arranged on or in the vicinity of the object plane and/or of the image plane.

## Revendications

1. Système d'éclairage pour une installation d'exposition par projection en microlithographie, dans lequel ledit système d'éclairage comprend :

- une source de lumière émettant de la lumière dans la gamme de longueurs d'onde < 100 nm, en particulier dans la gamme de longueurs d'onde EUV, pour illuminer un plan de pupille de sortie (121), ainsi que
- un élément optique (113) à facettes, avec une pluralité de miroirs à facettes à position variable, ledit élément permettant de modifier au moins une première illumination (22) dans le plan de pupille de sortie (121) en une deuxième illumination (24),

**caractérisé en ce que** le système d'éclairage comprend au moins un détecteur (106.1, 106.2) pour détecter la lumière et un dispositif (164) réalisé pour enregistrer au moins un signal d'intensité de lumière du détecteur (106.1, 106.2) et fournir un signal de commande (166) au moins en fonction du signal d'intensité de lumière enregistré et en tenant compte d'informations concernant l'illumination réglée dans le plan de pupille de sortie, ledit signal de commande permettant de régler une vitesse de balayage d'un objet photosensible dans un plan image (221) de l'installation d'exposition par projection en microlithographie.

2. Système d'éclairage selon la revendication 1, **caractérisé en ce que** le détecteur (106.1, 106.2) est disposé sur un chemin optique de la lumière de la source de lumière (100) au plan de pupille de sortie (121) entre la source de lumière (100) et le plan de pupille de sortie (121).

3. Système d'éclairage selon l'une quelconque des revendications 1 et 2, **caractérisé en ce que** le dispositif enregistre un premier signal de réglage représentant un premier réglage de l'élément, dans lequel le premier réglage fournit une première illumination (22).

4. Système d'éclairage selon la revendication 3, **caractérisé en ce que** le dispositif enregistre un deuxième signal de réglage représentant un deuxième réglage de l'élément optique (113) à facettes, dans lequel le deuxième réglage fournit une deuxième illumination (26).

**5.** Système d'éclairage selon l'une quelconque des revendications 1 à 4, **caractérisé en ce que** le dispositif présente une unité de régulation (1030, 164) avec une unité de mémoire dans laquelle sont stockées au moins une première valeur de calibrage pour la première illumination et une deuxième valeur de calibrage pour la deuxième illumination.

**6.** Système d'éclairage selon la revendication 5, **caractérisé en ce qu'**une pluralité de valeurs de calibrage constituant un tableau de calibrage est stockée dans l'unité de mémoire.

**7.** Système d'éclairage selon l'une quelconque des revendications 1 à 6, **caractérisé en ce que** l'objet photosensible est disposé sur une table de balayage (502) et la vitesse de balayage détermine la vitesse d'avance de la table de balayage.

**8.** Système d'éclairage selon la revendication 7, **caractérisé en ce que** l'objet photosensible (220) est une plaquette.

**9.** Système d'éclairage selon l'une quelconque des revendications 1 à 8, **caractérisé en ce qu'**un détecteur (160.1) est disposé sur le chemin optique de la source de lumière (100) au plan de pupille de sortie (121) après l'élément optique (113) à facettes pour modifier le réglage de l'illumination.

**10.** Système d'éclairage selon l'une quelconque des revendications 1 à 9, **caractérisé en ce qu'**un détecteur (160.2) est disposé sur le chemin optique de la source de lumière (100) au plan de pupille de sortie (121) avant l'élément optique (113) à facettes pour modifier le réglage de l'illumination.

**11.** Système d'éclairage selon l'une quelconque des revendications 1 à 10, **caractérisé en ce que** le détecteur (160.1, 160.2) est disposé au niveau ou à proximité de l'élément optique (113) à facettes pour modifier le réglage de l'illumination du plan de pupille de sortie.

**12.** Système d'éclairage selon l'une quelconque des revendications 1 à 11, **caractérisé en ce que** le détecteur (160.1, 160.2) est disposé au niveau ou à proximité d'un plan objet (200) ou du plan image (221) de l'installation d'exposition par projection en microlithographie.

**13.** Système d'éclairage selon l'une quelconque des revendications 1 à 12, **caractérisé en ce que** le système d'éclairage est un système d'éclairage catoptrique.

**14.** Système d'éclairage selon l'une quelconque des revendications 1 à 13, **caractérisé en ce que** le système d'éclairage comprend un autre élément optique (116) à facettes.

**15.** Système d'éclairage selon la revendication 14, **caractérisé en ce que** ledit autre élément optique (116) à facettes comprend une pluralité de miroirs à facettes (115, 115.1, 115.2).

**16.** Installation d'exposition par projection en microlithographie, comprenant un système d'éclairage selon l'une quelconque des revendications 1 à 15, avec un plan objet (200) et un objectif de projection (300) pour reproduire dans un plan image (221) un objet disposé dans le plan objet (200).

**17.** Installation d'exposition par projection en microlithographie selon la revendication 16, **caractérisée en ce que** l'objectif de projection (300) présente un diaphragme (B).

**18.** Procédé de réglage d'une énergie lumineuse substantiellement identique, en particulier d'une énergie lumineuse intégrée, suivant un chemin de balayage dans un plan image d'une installation d'exposition par projection en microlithographie pour des longueurs d'onde < 100 nm, en particulier des longueurs d'onde EUV, indépendamment de l'illumination d'un plan de pupille de sortie (121), dans lequel l'installation d'exposition par projection en microlithographie comprend un élément optique (113) à facettes avec une pluralité de miroirs à facettes à position variable pour modifier l'illumination dans le plan de pupille de sortie et un détecteur, comprenant les étapes suivantes :

- l'énergie lumineuse est mesurée avant la modification de l'illumination dans le plan de pupille de sortie ;
- l'énergie lumineuse est mesurée après la modification de l'illumination dans le plan de pupille de sortie ;
- un signal de différence de l'énergie lumineuse mesurée avant et après modification de l'illumination est formé, et sur la base du signal de différence, une vitesse de balayage d'un objet photosensible dans le plan image est réglée.

**19.** Procédé selon la revendication 18, **caractérisé en ce que** le signal de différence est enregistré en continu et amené à une unité de régulation, et la vitesse de balayage de l'objet photosensible dans le plan image est réglée en continu.

**20.** Procédé de réglage d'une énergie lumineuse substantiellement identique, en particulier d'une énergie lumineuse intégrée, suivant un chemin de balayage dans un plan image d'une installation d'exposition par projection en microlithographie pour des longueurs d'onde < 100 nm, en particulier des longueurs d'onde EUV, indépendamment de l'illumination d'un plan de pupille de sortie, dans lequel l'installation d'exposition par projection en microlithographie présente un élément optique (113) à facettes avec une pluralité de miroirs à facettes à position variable pour modifier l'illumination dans le plan de pupille de sortie et un détecteur, le procédé comprenant les étapes suivantes :

- l'énergie lumineuse est mesurée par un détecteur pour différentes illuminations dans le plan de pupille de sortie ;
- les valeurs mesurées sont stockées dans une unité de régulation sous forme de valeurs de calibrage ;
- une fois les valeurs de calibrage stockées, l'énergie lumineuse est déterminée au moyen du détecteur et comparée aux valeurs de calibrage stockées ;
- sur la base de la comparaison avec les valeurs de calibrage, une vitesse de balayage d'un objet photosensible dans un plan d'image est réglée.

**21.** Procédé selon la revendication 20, **caractérisé en ce que** les valeurs de calibrage sont stockées sous la forme d'un tableau de calibrage et/ou d'une courbe de calibrage.

**22.** Procédé selon l'une quelconque des revendications 18 à 21, **caractérisé en ce que** le détecteur est disposé au niveau ou à proximité de l'élément optique (113) à facettes pour modifier le réglage de l'illumination du plan de pupille.

**23.** Procédé selon l'une quelconque des revendications 18 à 22, **caractérisé en ce que** l'installation d'exposition par projection en microlithographie présente un plan objet et un plan image et le détecteur est disposé au niveau ou à proximité du plan objet et/ou du plan image.

Fig.1

Fig.2a

22

Fig.2b

24

Fig.3

EP 2 064 597 B1

## Fig.4a1

10000

J

0,5    1ms    t

Taktfrequenz

## Fig.4a2

w = 1mm

10003.1    10003.2

10001    10002

$v_1$= 1mm/ms

## Fig.4b1

J

10000

0,5ms    t

## Fig.4b2

10003.1    10003.2

10001    10002

$v_2$= 2mm/ms

Fig.5

KALIBRIERUNG                    MESSUNG

```
┌─────────────────────┐
│ KALIBRIER-          │ ── 1000
│ MESSUNG             │
└─────────────────────┘
          │
          ▼
┌─────────────────────┐
│ ABLEGEN DER MESS-   │
│ WERTE               │ ── 1010
│ IN KALIBRIER-       │
│ TABELLE             │
└─────────────────────┘
          │
          ▼
┌─────────────────────┐        ┌──────────────┐
│ REGELEINHEIT        │◄───────│ MESSWERT     │
└─────────────────────┘        └──────────────┘
          │      1030                 1040
          ▼
┌─────────────────────┐
│ VERGLEICH MESSWERT /│ ── 1045
│ KALIBRIERWERT       │
└─────────────────────┘
          │                              1060
          ▼
┌─────────────────────┐ ── 1050
│ EINSTELLEN DER      │
│ SCANGESCHWINDIG-    │────────┘
│ KEIT                │
└─────────────────────┘        Wiederholung der
          │                    Messung
          ▼
┌─────────────────────┐
│ BEENDEN DER         │ ── 1070
│ MESSUNG             │
└─────────────────────┘
```

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20050088760 A
- US 6438199 B
- US 6859328 B
- US 6658084 B
- EP 1291721 A
- EP 1355194 A
- US 20020190228 A
- WO 2004031854 A
- US 6885432 B
- US 20050110972 A
- US 6259510 B1
- US 2005011972 A
- WO 200227400 A
- US 6198793 B